# EUROPÄISCHE PATENTSCHRIFT

(11) **EP 0 534 576 B1**
(45) Veröffentlichungstag und Bekanntmachung des Hinweises auf die Patenterteilung: **19.04.1995**
(21) Anmeldenummer: 92250177.0
(22) Anmeldetag: 07.07.1992
(51) Int. Cl.: C23C 18/14

(54) **Verfahren zum Aufbringen von strukturierten Metallschichten auf Glassubstraten**
Process for the deposition of patterned metal layers on glass substrates
Procédé pour le dépôt de couches métalliques texturées sur substrats en verre

(30) Priorität: 03.08.1991 DE 4125863
(43) Veröffentlichungstag der Anmeldung: 31.03.1993
(73) Patentinhaber: LPKF CAD/CAM SYSTEME GMBH, D-30827 Garbsen (DE)
(72) Erfinder: Kickelhain, Jörg, W-3057 Neustadt 1 (DE)
(74) Vertreter: Brümmerstedt, Hans Dietrich, Dipl.-Ing.

(56) Entgegenhaltungen:
- EP-A- 0 357 124
- DD-A- 250 553
- RESEARCH DISCLOSURE, Nr. 291, Juli 1988, New York; ANONYMOUS: "Laser definition of circuits on seeded polyimide", Seite 494

## Beschreibung

Die Erfindung betrifft ein Verfahren zum Aufbringen von leitfähigen metallischen, strukturierten Schichten auf Glassubstraten.

Die Miniaturisierung von elektronischen Baugruppen und der darin verwendeten Leiterstrukturen erfordert immer geringere Leiterbahnbreiten und Leiterbahnabstände. Um maximale Packungsdichten der Funktionselemente zu erreichen, werden höchste Ansprüche an die Strukturgenauigkeit und Qualität der Isolationskanäle und Leiterbahnen gestellt.

Auch die Beschaffenheit des Substrats, auf das die strukturierte Schicht aufzubringen ist, spielt eine wichtige Rolle. So hat sich in der Mikroelektronik, insbesondere bei der Herstellung von integrierten Schaltungen, Quarzglas als Verdrahtungsträger mehr und mehr durchgesetzt, denn Quarzglas hat neben guten dielektrischen Eigenschaften den Vorteil, daß sein thermischer Ausdehnungskoeffizient ähnlich dem von Kupfer ist, das in der Regel für die Strukturierung verwendet wird.

Ein Problem stellt dabei jedoch das Anbringen der strukturierten Schicht auf der Quarzglasscheibe dar. Es ist bekannt, eine Kupferfolie durch Heißpressen auf das Quarzglas aufzubringen und anschließend die Strukturierung vorzunehmen. Dies kann durch aus der Herstellung von gedruckten Schaltungen bekannte Photo-Ätztechniken erfolgen. Hohe Leiterbahndichten sind dann jedoch wegen der bekannten Probleme wie begrenztes Auflösungsvermögen durch Lack- und Maskentechnik und durch Unterätzungen der Leiterbahnstruktur nicht möglich. Ferner ist es bekannt, die strukturierte Schicht durch Verdampfung von Kupfer über eine Maske auf dem Quarzglas aufzubringen. Ein solches CVD (Chemical Vapour Deposition)-Sputterverfahren geht mit einem hohen apparativen und funktionellen Aufwand einher, wobei charakteristisch Hochtemperaturbedingungen unter Reinraum- und Vakuumverhältnissen sind.

Der Erfindung liegt die Aufgabe zugrunde, ein Verfahren der eingangs genannten Art zu schaffen, das einerseits eine hohe Auflösung der Strukturierung ermöglicht und andererseits verfahrenstechnisch einen geringeren Aufwand als das Heißpreß- oder Sputterverfahren erfordert.

Die gestellte Aufgabe wird gemäß der Erfindung dadurch gelöst, daß in den Strahlengang eines Excimerlasers eine Maske mit dem Negativ der aufzubringenden Struktur gebracht wird, und daß die aus der Maske austretende Laserstrahlung auf eine plane Quarzglasscheibe gerichtet wird, deren Rückseite mit einem reduktiven Kupferbad in Kontakt ist.

Excimerlaser sind Edelgaslaser, die ihr emittiertes Licht in einer gewissen Fläche zur Verfügung stellen, und mit deren Hilfe sich überwiegend photolytische, kalte Reaktionen initiieren lassen, so daß damit in einem Schritt das gesamte Glassubstrat ohne abzurastern über eine Maske strukturierbar ist. Das Verfahren erlaubt insbesondere eine sehr hohe Auflösung im »m-Bereich, sowie einen Kantenscharfen, homogen abgeschiedenen Metallaufbau, welcher in der Dicke bestimmbar ist. Bemerkenswert ist dabei der kurze zeitliche Gesamtaufwand für diesen technologischen Prozeß. Mit Belichtungszeiten im Sekundenbereich ist der Prozeß des Strukturierens bereits abgeschlossen. Danach läuft der Abscheidungsprozeß selbständig (autokatalytisch) weiter und wird bei Erreichen der gewünschten Schichtdicke abgebrochen.

Vorzugsweise emittiert der Excimerlaser bei einer Wellenlänge im Bereich zwischen 157 bis 308 nm. Quarzglas besitzt für diesen Wellenlängenbereich der Laserstrahlung eine hohe Transmission.

Zweckmäßig wird das reduktive Kupferbad in eine Küvette gefüllt, wobei die Quarzglasscheibe eine Seitenwand der Küvette bildet. Dabei wird die Quarzglasscheibe vorzugsweise abdichtend und lösbar mit der Küvette verbunden.

Die Quarzglasscheibe kann aber auch schräg angeordnet und das reduktive Kupferbad in permanenter Strömung über die Rückseite geleitet werden.

Um die Haftfähigkeit auf der Scheibe zu erhöhen, ist es von Vorteil, zuvor die zu beschichtende Oberfläche der Glasscheibe vorzubehandeln, z.B. aufzurauhen oder anzuätzen.

Die Erfindung wird nachfolgend anhand von in der Zeichnung dargestellten Ausführungsbeispielen näher erläutert. In der Zeichnung stellen dar:
- Fig. 1: den apparativen Aufbau zur Durchführung des erfindungsgemäßen Verfahrens und
- Fig. 2: einen alternativen apparativen Aufbau.

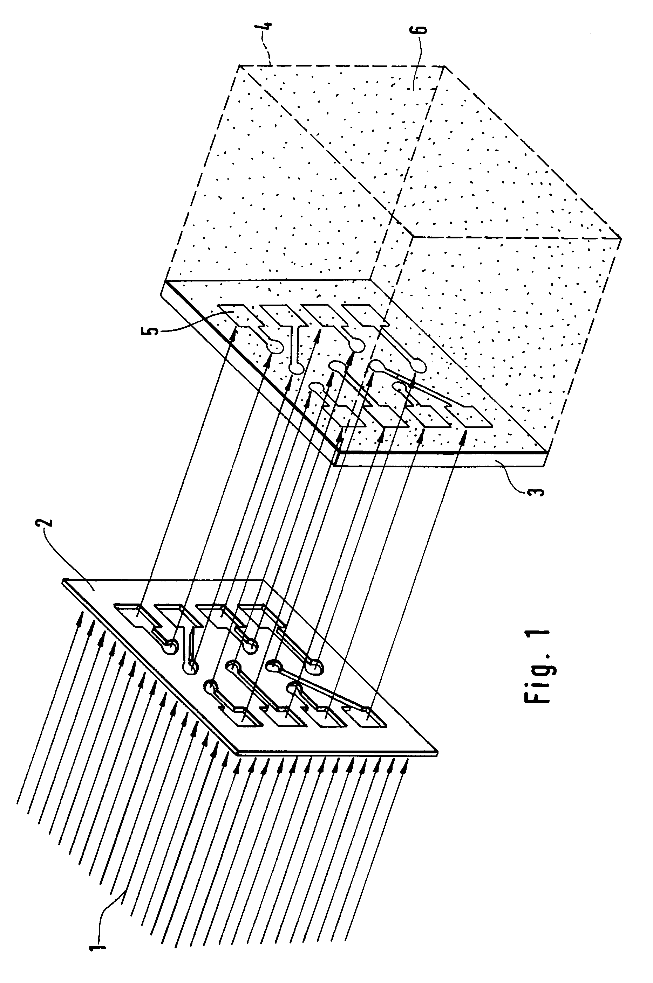

Bei der in Fig. 1 dargestellten Vorrichtung liegt im Weg der von einem Excimerlaser ausgesendeten Strahlung 1, deren Wellenlänge z.B. 248 nm beträgt, eine Maske 2, die aus CrNi, Messing, bedampftem Quarzglas oder dergl. besteht, und auf welcher sich das entsprechende Leiterbahn-Layout oder die abzuscheidende Struktur im Negativ befindet. Diese Maske 2 befindet sich auf oder in der Nähe der Außenseite der zu beschichtenden Quarzglasscheibe 3, ist jedoch in der Zeichnung in übertrieben großem Abstand dargestellt. Beugungen an den Kanten der Maske, die zu einer Verzerrung der Abbildung führen könnten, treten aufgrund der Wellenlänge des verwendeten Laserlichtes nicht auf. Die Quarzglasscheibe 3 bildet die eine Seitenwand einer Küvette 4, in der sich ein reduktives Kupferbad 6 (auch als "chemisch Kupfer" bezeichnet) befindet. Die Quarzglasscheibe ist vorzugsweise lösbar aber abdichtend an der Küvette befestigt.

An den Stellen, wo die Laserstrahlung ungehindert die Maske passieren kann und somit durch das Quarzglas hindurch auf die Phasengrenzschicht Glas/reduktives Kupferbad trifft, findet eine selektive, haftfeste Abscheidung des Metalls an der Innenseite des Quarzglases statt (voll additiver Leiterbahnaufbau). Aufgrund der kurzen Wellenlänge (ultraviolett) des benutzten Laserlichtes und der damit verbundenen hohen Photonen-Energien werden photolytische Reaktionen an der Phasengrenzschicht Quarzglas/reduktives Bad ausgelöst, wobei es zum haftfesten Abscheiden des Kupfers entsprechend dem Muster 5 des von der Maske 2 durchgelassenen Laserlichtes an der Quarzglaswand kommt.

Das von dem Excimerlaser emittierte Licht steht beispielsweise auf einer Fläche von 6 cm mal 6 cm mit der zum Abscheidevorgang benötigten Ernergiedichte bis 600 mJ/cm² zur Verfügung, so daß bei nicht größer gefordertem Layout die gesamte Quarzglasscheibe in einem Schritt strukturiert werden kann.

Die Belichtungszeit liegt im Sekundenbereich, und nach der Belichtung läuft der Abscheidungsprozeß autokatalytisch mit einer Abscheidegeschwindigkeit von ca. 3 - 15 »m/h weiter, so daß der Abscheidungsprozeß bei Erreichen der gewünschten Schichtdicke abgebrochen werden kann.

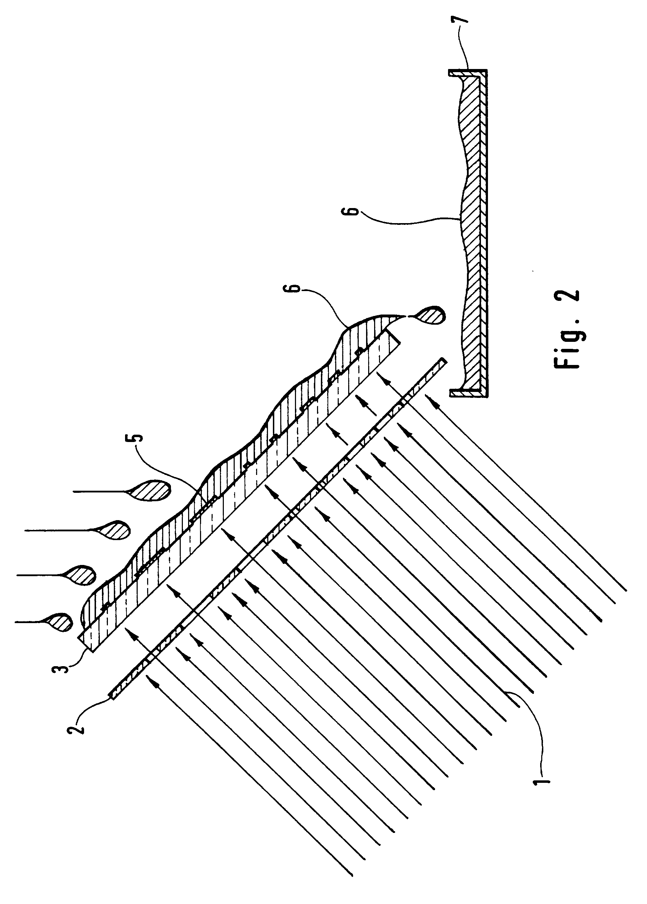

Bei dem Ausführungsbeispiel gemäß Fig. 2 ist die Quarzglasscheibe 3 geneigt angeordnet, und das reduktive Kupferbad 6 wird im Umlauf über die Rückseite der Quarzglasscheibe 3 aus einem Behälter 7 und zurück zu diesem geleitet. Auch ein Ansprühen der Rückseite der Quarzglasscheibe 3 mit dem Bad ist möglich.

Um die Haftfähigkeit der Schicht auf der Quarzglasscheibe zu erhöhen, ist es zweckmäßig, deren Rückseite z.B. durch Aufrauhen oder Anätzen vorzubehandeln.

## Patentansprüche

1. Verfahren zum Aufbringen von leitfähigen metallischen, strukturierten Schichten auf Glassubstraten, dadurch gekennzeichnet, daß in den Strahlengang eines Excimerlasers eine Maske (2) mit dem Negativ der aufzubringenden Struktur gebracht wird, und daß die aus der Maske (2) austretende Laserstrahlung auf eine plane Quarzglasscheibe (3) gerichtet wird, deren Rückseite mit einem reduktiven Kupferbad in Kontakt ist.

2. Verfahren nach Anspruch 1, dadurch gekennzeichnet, daß der Excimerlaser mit einer Wellenlänge im Bereich zwischen 157 bis 308 nm arbeitet.

3. Verfahren nach Anspruch 1 oder 2, dadurch gekennzeichnet, daß die Maske (2) auf der Vorderseite der Quarzglasscheibe (3) angebracht wird.

4. Verfahren nach einem der Ansprüche 1 bis 3, dadurch gekennzeichnet, daß das reduktive Kupferbad (6) in eine Küvette (4) gefüllt wird und die Quarzglasscheibe (3) eine Seitenwand der Küvette bildet.

5. Verfahren nach Anspruch 4, dadurch gekennzeichnet, daß die Quarzglasscheibe (3) abdichtend und lösbar mit der Küvette (4) verbunden wird.

6. Verfahren nach einem der Ansprüche 1 bis 3, dadurch gekennzeichnet, daß die Quarzglasscheibe (3) schräg angeordnet wird und das reduktive Kupferbad (6) in permanenter Strömung über die Rückseite geleitet wird.

7. Verfahren nach einem der Ansprüche 1 bis 3, dadurch gekennzeichnet, daß das reduktive Kupferbad (6) an die Rückseite der Quarzglasscheibe gesprüht wird.

8. Verfahren nach einem der vorhergehenden Ansprüche, dadurch gekennzeichnet, daß die zu beschichtende Oberfläche der Quarzglasscheibe (3) vorbehandelt wird, um die Haftfähigkeit für die Schicht zu erhöhen.

9. Verfahren nach Anspruch 8, dadurch gekennzeichnet, daß die Oberfläche aufgerauht oder angeätzt wird.

## Claims

1. Method of applying conductive, metallic, structured coatings onto glass substrates, characterized in that a mask (2) having the negative of the structure to be applied is placed in the beam path of an excimer laser, and that the laser beam issuing through the mask (2) is directed onto a plane quartz glass sheet (3), the rear face of which is in contact with a reductive copper bath.

2. Method according to Claim 1, characterized in that the excimer loser operates with a wavelength in the range between 157 and 308 nm.

3. Method according to Claim 1 or 2, characterized in that the mask (2) is applied onto the front face of the quartz glass sheet (3).

4. Method according to one of Claims 1 to 3, characterized in that the reductive copper bath (6) is placed in a vessel (4) and the quartz glass sheet (3) forms one lateral wall of the vessel.

5. Method according to Claim 4, characterized in that the quartz glass sheet (3) is sealingly and releasably connected to the vessel (4).

6. Method according to one of Claims 1 to 3, characterized in that the quartz glass sheet (3) is mounted obliquely and the reductive copper bath (6) is conducted in continuous flow over the rear face.

7. Method according to one of Claims 1 to 3, characterized in that the reductive copper bath (6) is sprayed onto the rear face of the quartz glass sheet.

8. Method according to one of the preceding Claims, characterized in that the surface of the quartz glass sheet (3) to be coated is pretreated in order to increase the bond for the coating.

9. Method according to Claim 8, characterized in that the surface is roughened or etched.

## Revendications

1. Procédé pour déposer des couches structurées métalliques et conductrices sur des substrats de verre, caractérisé en ce que, sur le trajet des rayons d'un laser excimer, est placé un masque (2) comportant le négatif de la structure à déposer et en ce que le rayonnement laser qui sort du masque (2) est dirigé sur une plaque plane de verre de quartz (3) dont la face arrière est en contact avec un bain de cuivre réducteur.

2. Procédé suivant la revendication 1, caractérisé en ce que le laser excimer fonctionne avec une longueur d'onde dans la plage de 157 à 308 nm.

3. Procédé suivant la revendication 1 ou 2, caractérisé en ce que le masque (2) est appliqué sur la face avant de la plaque de verre de quartz (3).

4. Procédé suivant l'une des revendications 1 à 3, caractérisé en ce que le bain de cuivre réducteur (6) est versé dans une cuve (4) et en ce que la plaque de verre de quartz (3) forme une paroi latérale de la cuve.

5. Procédé suivant la revendication 4, caractérisé en ce que la plaque de verre de quartz (3) est reliée, d'une manière étanche et amovible, à la cuve (4).

6. Procédé suivant l'une des revendications 1 à 3, caractérisé en ce que la plaque de verre de quartz (3) est inclinée et le bain de cuivre réducteur (6) est parcouru par un courant permanent sur la face arrière.

7. Procédé suivant l'une des revendications 1 à 3, caractérisé en ce que le bain de cuivre réducteur (6) est projeté sur la face arrière de la plaque de verre de quartz.

8. Procédé suivant l'une des revendications précédentes, caractérisé en ce que la surface de la plaque de verre de quartz (3) qui doit recevoir le dépôt est préalablement traitée pour augmenter sa propriété adhésive pour la couche.

9. Procédé suivant la revendication 8, caractérisé en ce que la surface est rugueuse ou décapée.
